Europäisches Patentamt

European Patent Office

Office européen des brevets

(19)

(11) **EP 0 986 224 A2**

(12) **DEMANDE DE BREVET EUROPEEN**

(43) Date de publication:
**15.03.2000 Bulletin 2000/11**

(51) Int. Cl.⁷: **H04L 27/38**, H03J 7/04

(21) Numéro de dépôt: **99202731.8**

(22) Date de dépôt: **24.08.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **01.09.1998 FR 9810915**

(71) Demandeur:
**Koninklijke Philips Electronics N.V.
5621 BA  Eindhoven (NL)**

(72) Inventeurs:
• **Rouvellou, Laurent**
  **75008 Paris (FR)**
• **Chouly, Antoine**
  **75008 Paris (FR)**

(74) Mandataire:
**den Braber, Gerard Paul
Société Civile "S.P.I.D.",
156, Boulevard Haussmann
75008 Paris (FR)**

(54) **Estimation de l'atténuation et du décalage en fréquence**

(57) L'invention permet d'estimer le décalage en fréquence introduit par un support de transmission à partir de la transmission d'un signal sinusoïdal de fréquence connue. Deux échantillons déphasés de $\pm\Pi/2+p.2\Pi$ (où p est un entier naturel) sont multipliés pour obtenir un fonction trigonométrique dudit décalage en fréquence.

L'estimation ainsi obtenue est avantageusement appliquée pour corriger des signaux de test reçus pendant une période d'apprentissage précédant une période de transmission entre un émetteur et un récepteur. Elle est également applicable pour initialiser des algorithmes adaptatifs de récupération de rythme ou d'annulation d'écho au niveau du récepteur.

Application: tout système de transmission qui utilise une ou plusieurs porteuses, et qui permet de transmettre un signal sinusoïdal à un instant donné, notamment recommandation V34 du CCITT.

FIG. 3

EP 0 986 224 A2

**Description**

L'invention concerne un système de transmission entre au moins un émetteur et au moins un récepteur par l'intermédiaire d'un support de transmission susceptible d'introduire un décalage en fréquence et une atténuation, ledit émetteur comportant des moyens d'émission d'un signal sinusoïdal de fréquence connue, et ledit récepteur comportant des moyens de réception dudit signal sinusoïdal et des moyens d'estimation dudit décalage en fréquence à partir du signal sinusoïdal reçu. L'invention concerne également un récepteur destiné à être utilisé dans un tel système, par exemple un modem.

L'invention concerne aussi un procédé d'estimation du décalage en fréquence introduit sur une porteuse par un support de transmission, comportant une étape de transmission d'un signal sinusoïdal de fréquence connue, ainsi qu'un programme d'ordinateur destiné à mettre oeuvre ce procédé d'estimation de décalage en fréquence. Elle concerne enfin un procédé de test d'un support de transmission susceptible d'introduire un décalage en fréquence, ledit procédé comportant des étapes d'émission de signaux de test connus, de réception desdits signaux de test, et d'analyse des signaux de test reçus pour en déduire des propriétés dudit support.

L'invention s'applique à tous les systèmes de transmission qui utilisent une ou plusieurs porteuses et qui permettent de transmettre, au moins à un instant donné, un signal sinusoïdal. Elle s'applique en particulier aux modems, notamment à la recommandation V34 du CCITT.

Le brevet américain n°5,206,886 décrit un système de transmission multiporteuses qui comporte des moyens d'estimation du décalage en fréquence introduit par le support de transmission. L'estimation obtenue est utilisée, au début de la phase de transmission de données, pour initialiser les algorithmes adaptatifs de récupération de porteuse du récepteur. La méthode d'estimation proposée est une méthode adaptative complexe basée sur la transmission de deux signaux sinusoïdaux de fréquences connues f1 et f2. A la réception ces signaux sont séparés par filtrage et leur phase $\phi1(t)$ et $\phi2(t)$ sont calculées en fonction du temps (ce calcul fait intervenir un calcul d'arc - tangente pour chaque signal et chaque instant considéré). Les fonctions sont ensuite analysées pour obtenir ladite estimation.

L'invention a notamment pour but de proposer une autre méthode beaucoup plus simple d'estimation du décalage en fréquence introduit par le support de transmission.

Ce but est atteint avec le système de transmission tel que défini dans le paragraphe introductif et caractérisé en ce que, lesdits moyens d'estimation comportent des moyens d'échantillonnage du signal sinusoïdal reçu par le récepteur, des moyens de déphasage pour fournir des échantillons du signal sinusoïdal reçu déphasés de $+\Pi/2+p.2\Pi$ où p est un entier naturel, des moyens de calcul de ladite atténuation à partir d'au moins deux desdits échantillons déphasés, et des moyens de calcul dudit décalage en fréquence, à partir d'au moins deux desdits échantillons déphasés et de l'atténuation calculée.

La méthode proposée est particulièrement simple et donc peu coûteuse en termes de puissance de calcul.

Dans un mode de réalisation particulièrement simple à mettre en oeuvre, les moyens de calcul de ladite atténuation comportent des moyens de calcul d'une valeur moyenne d'une somme du carré de deux échantillons déphasés de $+\Pi/2$.

Lorsque le récepteur comporte un filtre de réception, les moyens de calcul dudit décalage en fréquence utilisent deux échantillons déphasés de $+\Pi/2+p.2\Pi$ où la valeur de p est choisie de façon à ce que lesdits échantillons soient décorrélés.

Dans un mode de réalisation avantageux, les moyens de calcul du décalage en fréquence comportent des moyens de calcul d'une valeur moyenne d'un produit desdits échantillons pour fournir une fonction trigonométrique dudit décalage. Lorsque le signal reçu n'est pas filtré on choisit avantageusement p=0. Dans ce cas, l'invention n'implique qu'un seul calcul de fonction trigonométrique.

L'invention propose également une autre utilisation d'une estimation dudit décalage en fréquence. En effet, conformément à l'invention, un système tel que décrit dans le paragraphe introductif qui comporte des moyens de test dudit support de transmission notamment par émission, réception puis analyse de signaux de test connus pour en déduire des propriétés dudit support, comporte également des moyens de correction dudit décalage, lors de la réception d'au moins certains desdits signaux de test.

Il est ainsi possible de réduire l'effet du décalage en fréquence sur la modélisation du support de transmission, en particulier sur l'évaluation du rapport signal à bruit. Cette évaluation du rapport signal à bruit est notamment utilisée pour choisir au niveau d'un émetteur un débit d'émission sur le support de transmission. L'invention permet en particulier d'éviter que le décalage en fréquence introduit par le support soit interprété comme du bruit, c'est-à-dire que le rapport signal à bruit soit surestimé, et donc que le débit de transmission soit sous estimé.

L'invention sera mieux comprise et d'autres détails apparaîtront dans la description qui va suivre en regard des dessins annexés qui sont donnés à titre d'exemple non limitatifs et dans lesquels:

- la figure 1 représente un premier exemple de système de transmission selon l'invention,
- la figure 2 représente un second exemple de système de transmission selon l'invention,

- la figure 3 représente un schéma en blocs de moyens d'estimation du décalage en fréquence selon l'invention,
- la figure 4 représente un organigramme d'un exemple de procédé d'estimation du décalage en fréquence selon l'invention,
- la figure 5 représente un schéma en blocs d'un exemple de circuit de correction de signaux de test selon l'invention,
- la figure 6 représente un organigramme d'un exemple de procédé de test selon l'invention.

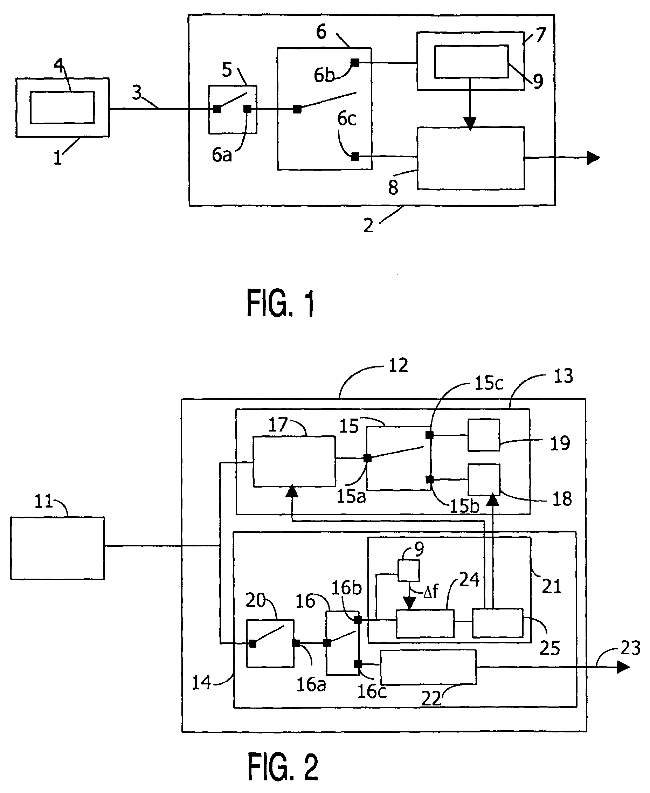

Sur la figure 1 on a représenté un premier exemple de système de transmission selon l'invention. Ce système comporte un émetteur 1 et un récepteur 2 communiquant entre eux par l'intermédiaire d'un support de transmission 3. A titre d'exemple ce support de transmission peut être une voie hertzienne, une ligne téléphonique...

L'établissement d'une connexion entre un émetteur 1 et un récepteur 2 comporte une phase d'apprentissage suivie d'une phase de transmission de données. L'émetteur 1 comporte des moyens 4 pour émettre au moins une sinusoïde s(t) de fréquence connue $f_0$, durant la phase d'apprentissage. Le récepteur 2 comporte des moyens 5 d'échantillonnage des signaux reçus. Il est doté de deux modes de fonctionnement distincts pour la phase d'apprentissage d'une part et pour la phase de transmission de données d'autre part. Ceci est symbolisé sur la figure 1 par un circuit de commutation 6 qui relie la sortie 6a des moyens d'échantillonnage 5 à l'entrée 6b d'un circuit de test 7 en phase d'apprentissage et, en phase de transmission de données, à rentrée 6c d'un circuit de traitement du signal classique 8 qui délivre des données de sortie. Le circuit de test 7 comporte notamment des moyens 9 d'estimation du décalage en fréquence $\Delta f$ introduit sur le signal sinusoïdal s(t) par le support de transmission. L'estimation $\Delta f$ obtenue est transmise aux moyens 8 de traitement du signal, par exemple pour initialiser des algorithmes adaptatifs classiques tels que des algorithmes de récupération de rythme ou/et d'annuleur d'écho.

Sur la figure 2 on a représente un second exemple de système de transmission selon l'invention. Ce système 10 comporte deux modems 11 et 12 identiques (seul le modem 11 est représenté en détails sur la figure 2).

Une connexion entre un modem appelant et un modem appelé comporte une phase d'apprentissage suivie d'une phase de transmission de données. Le modem 11 comporte donc un circuit demission 13 et un circuit de réception 14 susceptibles de fonctionner en mode apprentissage et en mode transmission de données. Ceci est représenté symboliquement sur la figure 2 par deux circuits de commutation 15 et 16.

Le circuit de commutation 15 fait partie des moyens d'émission 13. En phase d'apprentissage il relie l'entrée 15a d'un circuit d'émission 17 à la sortie 15b d'une source 18 de signaux de test. En phase transmission de données, il relie l'entrée 15a du circuit d'émission 17 à la sortie 15c d'une source de données 19. En particulier en phase d'apprentissage, chacun des modems émet un signal de test qui est une sinusoïde s(t) de fréquence connue fo destiné à estimer le décalage en fréquence introduit par le support de transmission.

Le circuit de commutation 16 fait partie des moyens de réception 14. En phase d'apprentissage il relie la sortie 16a de moyens d'échantillonnage 20 des signaux reçus a l'entrée 16b d'un circuit de test 21. En phase transmission de données, il relie la sortie 16a des moyens d'échantillonnage 20 à l'entrée 16c d'un circuit classique 22 de traitement du signal reçu qui délivre des données de sortie 23. Le circuit de test 21 comporte notamment des moyens 9 d'estimation du décalage en fréquence $\Delta f$ introduit sur le signal de test s(t) par le support de transmission, des moyens de correction 24 des signaux de test reçus pendant la phase d'apprentissage en fonction de l'estimation $\Delta f$ obtenue, et des moyens 25 de traitement des signaux de test corrigés. Ces moyens de traitement 25 fournissent des informations au circuit d'émission 17 et des commandes à la source 18 de signaux de test.

Dans un mode de réalisation avantageux de l'invention, l'estimation $\Delta f$ obtenue est également transmise aux moyens 22 de traitement du signal, par exemple pour initialiser des algorithmes adaptatifs classiques de récupération de rythme ou/et d'annuleur d'écho.

Dans un autre mode de réalisation de l'invention, le circuit de test 21 comporte en amont des moyens d'évaluation 9, un filtre de réception 26 qui permet de s'affranchir de signaux d'écho susceptibles d'être transmis par la ligne téléphonique.

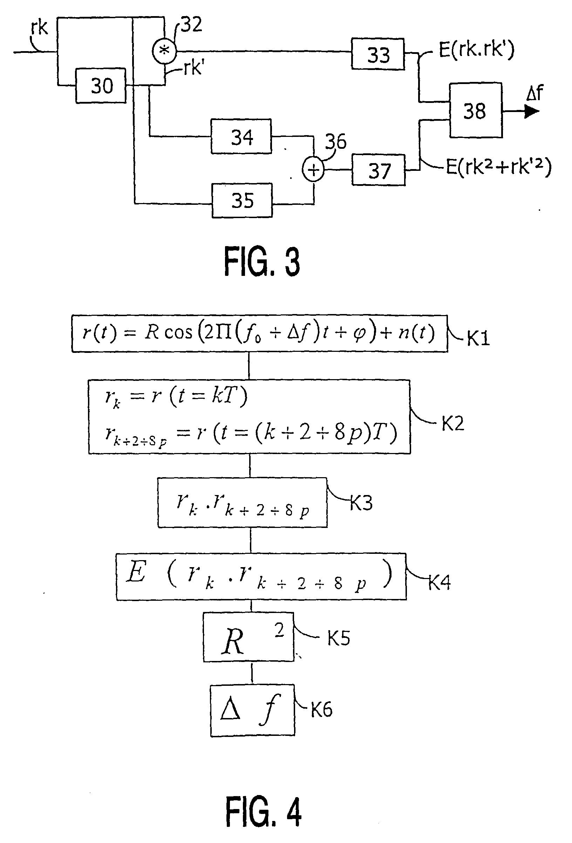

Sur la figure 3 on a representé en détails les moyens 9 d'estimation du décalage en fréquence. A l'instant t=kT , ces moyens 9 d'estimation reçoivent en entrée un échantillon $r_k$ du signal reçu r(t). Ils comportent notamment des moyens de déphasage 30 qui fournissent un échantillon $r_k'$ qui est déphasé d'un multiple de $\pm\Pi/2$ par rapport à cet échantillon $r_k$, et des moyens 31 de combinaison des échantillons $r_k$ et $r_k'$ qui fournissent une fonction trigonométrique du décalage en fréquence $\Delta f$. Les moyens de combinaison 31 comportent:

- des moyens 32 de multiplication des échantillons $r_k$ et $r_k'$,
- des moyens 33 de calcul de la valeur moyenne $E(r_k \cdot r_k')$,
- des moyens 34 et 35 de calcul des carrés $r_k^2$ et $r_k'^2$ desdits échantillons,
- des moyens 36 de sommation desdits carrés
- des moyens 37 de calcul de la valeur moyenne $E(r_k^2 + r_k'^2)$ de ladite somme,
- des moyens 38 de calcul à partir des grandeurs $E(r_k r_k')$ et $E(r_k^2 + r_k'^2)$ ainsi obtenues d'une fonction trigonométrique du décalage en fréquence $\Delta f$.

En effectuant le produit de deux échantillons déphasés de $\Pi/2+p.2\Pi$ (où p est un entier), on obtient une expression proportionnelle au produit du carré de l'amplitude du signal reçu et d'une somme de deux cosinus dont l'un est égal au sinus d'un multiple de $\Delta f$. En moyennant l'expression obtenue, on extrait ce terme en sinus. Parallèlement l'atténuation introduite par le support de transmission est évaluée en calculant la valeur moyenne de la somme des carrés de deux échantillons déphasés de $\Pi/2$.

On va maintenant décrire, à titre d'exemple et en référence à la figure 4, un mode de réalisation des moyens d'évaluation 9 pour des modems conformes à la norme V34 définie par le CCITT. Cette norme prévoit que pendant la phase d'apprentissage: - le modem appelant émette vers le modem appelé un signal B de fréquence $f_0$=1200Hz (c'est-à-dire 1/8 de la fréquence d'échantillonnage $f_s$=9600Hz du récepteur), - et le modem appelé émette vers le modem appelant un signal A de fréquence $f_0$=2400Hz (c'est-à-dire 1/4 de la fréquence d'échantillonnage $f_s$=9600Hz du récepteur). Ce sont ces signaux A et B qui sont utilisés ici comme signaux de test pour l'évaluation du décalage en fréquence $\Delta f$. Dans ce mode de réalisation, la fréquence d'échantillonnage du récepteur est donc un multiple de la fréquence initiale du signal de test. De façon avantageuse, on tient compte de cette particularité pour obtenir des échantillons $r_{k,p}'$ déphasés de $+\Pi/2+p.2\Pi$ (où p est un entier naturel) de façon particulièrement simple:

- pour le signal B, $r_{k,p}'=r_{k+2+8p}$
- pour le signal A, $r_{k,p}'=r_{k+1+4p}$

Le calcul du décalage $\Delta f$ va maintenant être décrit pour le signal B (fo=1200Hz). Le signal B transmit par l'émetteur s'écrit:

$s(t) = S \cos(2\Pi f_0 t)$ où $f_0$ est la fréquence et $S$ l'amplitude.

Le modem distant reçoit ce signal à l'étape K1 avec une atténuation, du bruit, et un décalage en fréquence. On note r(t) le signal reçu:

$$r(t) = R \cos(2\Pi(f_0 + \Delta f)t + \varphi) + n(t)$$

où R est l'atténuation introduite par le support de transmission, $\Delta f$ est le décalage en fréquence que l'on cherche à évaluer, $\varphi$ est une phase et n(t) est un bruit blanc.

A l'étape K2, ce signal reçu r(t) est échantillonné à la fréquence

$$f_s = \frac{1}{T} = 8f_0.$$

L'échantillon $r_k$ obtenu à l'instant t=kT s'écrit donc de la façon suivante:

$$r_k = r(t = kT) = R \cos(2\Pi(f_0 + \Delta f)kT + \varphi) + n(kT)$$

$$r_k = R \cos\left(\frac{2\Pi k}{8} + \frac{2\Pi k\Delta f}{8f_0} + \varphi\right) + n_k \text{ avec } n_k\text{=}n(kT)$$

$$r_k = R \cos\left(\frac{\Pi k}{4} + \frac{\Pi k\Delta f}{4f_0} + \varphi\right) + n_k$$

Le décalage $\Delta f$ va être extrait en multipliant (étape K3) deux échantillons $r_k$ et $r_{k+2+8p}$ déphasés de $+\Pi/2+p2\Pi$ où p est un entier naturel:

$$r_k r_{k+2+8p} = R^2 \cos\left(\frac{\Pi k}{4} + \frac{\Pi k\Delta f}{4f_0} + \varphi\right)\cos\left(\frac{\Pi k}{4} + \frac{\Pi k\Delta f}{4f_0} + \frac{\Pi}{2} + \frac{(4p + 1)\Pi\Delta f}{2f_0} + \varphi\right) + n_k'$$

où $n_k'$ est un terme de bruit.

$$r_k r_{k+2+8p} = \frac{R^2}{2}\left[\cos\left(\frac{\Pi k}{2} + \frac{\Pi k\Delta f}{2f_0} + 2\varphi + \frac{\Pi}{2} + \frac{\Pi\Delta f}{2f_0} + \frac{2p\Pi\Delta f}{f_0}\right) + \cos\left(\frac{\Pi}{2} + \frac{(4p + 1)\Pi\Delta f}{2f_0}\right)\right] + n_k'$$

$$r_k r_{k+2+8p} = \frac{R^2}{2}\left[\cos\left(\frac{\Pi}{2}(k+1) + \frac{\Pi\Delta f}{2f_0}(k+1) + 2\left(\varphi + p\frac{\Pi\Delta f}{f_0}\right)\right) - \sin\left(\frac{(4p+1)\Pi\Delta f}{2f_0}\right)\right] + n'_k$$

$$r_k r_{k+2+8p} = \frac{R^2}{2}\left[\cos\left(\frac{\Pi}{2}(k+1)\left(1 + \frac{\Delta f}{f_0}\right) + 2\left(\varphi + p\frac{\Pi\Delta f}{f_0}\right)\right) - \sin\left(\frac{(4p+1)\Pi\Delta f}{2f_0}\right)\right] + n'_k$$

On obtient donc trois termes:

1. une composante continue:

$$-\frac{R^2}{2}\sin\left(\frac{(4p+1)\Pi\Delta f}{2f_0}\right).$$

2. une composante de fréquence

$$2(f_0 + \Delta f): \frac{R^2}{2}\cos\left(\frac{\Pi}{2}(k+1)\left(1 + \frac{\Delta f}{f_0}\right) + 2\left(\varphi + p\frac{\Pi\Delta f}{f_0}\right)\right)$$

3. un bruit.

Seul le premier terme est intéressant pour évaluer Δf. Il faut donc s'affranchir des deux autres termes. Ceci est obtenu en calculant une valeur moyenne de $r_k r_{k+2+8p}$, à condition que le bruit soit un bruit blanc (étape K4). En effet:

-   le terme de fréquence $2(f_0 + \Delta f)$ est filtré par le filtre passe-bas qui est utilisé pour calculer la valeur moyenne,
-   l'espérance d'un bruit blanc est nulle,
-   et donc, dans le cas d'un bruit blanc, on obtient l'équation (1) suivante:

$$E(r_k r_{k+2+8p}) = -\frac{R^2}{2}\sin\left(\frac{(4p+1)\Pi\Delta f}{2f_0}\right) \qquad (1)$$

En l'absence de filtrage du signal reçu, le bruit est effectivement blanc quelque soit la valeur de p. puisque le bruit n(t) est blanc. On choisit alors avantageusement p=0, de telle sorte que

$$\sin\left(\frac{\Pi\Delta f}{2f_0}\right) \approx \frac{\Pi\Delta f}{2f_0}.$$

On évite ainsi d'avoir à calculer la fonction trigonométrique Arcsinus pour obtenir le décalage en fréquence Δf.
En revanche lorsque le circuit de test 21 comporte des moyens de filtrage 26, le bruit n'est blanc que si les k[ème] et (k+2+8p)[ème] échantillons sont décorrélés. Ceci est obtenu en choisissant une valeur pour p suffisamment grande (la valeur 8p+2 doit être au moins égale au nombre de coefficients de la fonction de transfert du filtre).
Il reste ensuite à estimer le terme $R^2$ qui n'est pas connu (étape K5). Pour cela on utilise par exemple la méthode suivante:

$$r_k = R\cos\left(\frac{\pi k}{4} + \frac{\pi k\Delta f}{4f_0} + \varphi\right) + n_k$$

et

$$r_{k+2+8p} = R\cos\left(\Phi_k + \frac{\Pi}{2} + (8p+1)\frac{\Pi\Delta f}{2f_0}\right) + n_{k+2+8p} \quad \text{avec} \quad \Phi_k = \frac{\Pi k}{4} + \frac{\Pi k\Delta f}{4f_0} + \varphi$$

Si l'on considère que $\Delta f_{max} \leq 12Hz$, et p=0, la phase maximum $\Theta$ introduite par $\Delta f$ est négligeable:

$$\Theta_{max} = \frac{\Pi \Delta f_{max}}{2f_0} = 0.9°.$$

On peut donc écrire que

$$r_{k+2} \approx R \cos\left(\Phi_k + \frac{\Pi}{2}\right) + n_{k+2} = R \sin(\Phi_k) + n_{k+2}$$

Pour extraire $R^2$ on calcule $r_k^2 + r_{k+2}^2$ :

$$r_k^2 + r_{k+2}^2 = R^2 (\cos^2(\Phi_k) + \sin^2(\Phi_k)) + n_k'$$

avec

$$n_k' = 2R \cos(\Phi_k)n_k + n_k^2 + 2R \sin(\Phi_k)n_{k+2} + n_{k+2}^2$$

Donc

$$r_k^2 + r_{k+2}^2 = R^2 + n_k'$$

et

$$E(r_k^2 + r_{k+2}^2) = R^2 + E(n_k')$$

$$E(n_k') = E(2R \cos(\Phi_k)n_k + n_k^2 + 2R \sin(\Phi_k)n_{k+2} + n_{k+2}^2) = 2\sigma^2$$

où $\sigma$ est la variance du bruit.

$$E(r_k^2 + r_{k+2}^2) = R^2 + 2\sigma^2$$

avec $\sigma^2 \ll R^2$
En négligeant le terme $\sigma^2$ devant le terme $R^2$, on obtient l'estimation (2):

$$E(r_k^2 + r_{k+2}^2) \approx R^2 \qquad (2)$$

En remplaçant dans l'équation (1) $R^2$ par son estimation (2) on obtient:

$$E(r_k r_{k+2+8p}) = -\frac{E(r_k^2 + r_{k+2}^2)}{2}\sin\left(\frac{(4p+1)\Pi \Delta f}{2f_0}\right)$$

c'est-à-dire:

$$\sin\left(\frac{(4p+1)\Pi \Delta f}{2f_0}\right) = -\frac{2E(r_k r_{k+2+8p})}{E(r_k^2 + r_{k+2}^2)}$$

Pour éviter toute ambiguïté il faut donc choisir:

$$-\frac{\Pi}{2} \le \frac{(4p + 1)\Pi\Delta f}{2f_0} \le \frac{\Pi}{2},$$

ce qui donne une condition supplémentaire à remplir lors du choix de la valeur de l'entier naturel p.

On obtient alors (étape K6) l'estimation $\hat{\Delta} f_{1200}$ du décalage $\Delta f$ pour $f_0$=1200Hz:

$$\hat{\Delta} f_{1200} = \frac{2f_0}{(4p + 1)\Pi}\sin^{-1}\left(-\frac{2E(r_k r_{k+2+8p})}{E(r_k^2 + r_{k+2}^2)}\right)$$

Les mêmes calculs sont applicables pour obtenir l'estimation $\hat{\Delta} f_{2400}$ du décalage $\Delta f$ pour $f_0$=2400Hz:

$$\hat{\Delta} f_{2400} = \frac{2f_0}{(4p + 1)\Pi}\sin^{-1}\left(-\frac{2E(r_k r_{k+1+4p})}{E(r_k^2 + r_{k+1}^2)}\right).$$

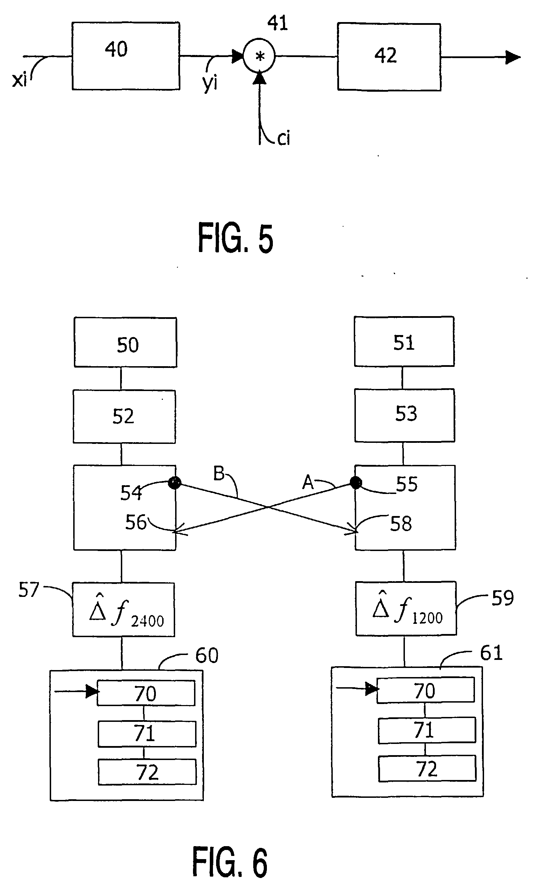

Sur la figure 5, on a représenté en détail un exemple de réalisation des moyens de correction 24 des signaux de test x(t) reçus pendant la suite de la phase d'apprentissage. Ils comportent un filtre de Hilbert 40 pour convertir chaque échantillon réel $x_i$ du signal reçu x(t) en un échantillon complexe $y_i$, un multiplicateur 41 pour multiplier cet échantillon complexe par un échantillon de correction $c_i = e^{j\Theta_i}$ avec $\Theta_i = -2\Pi. \hat{\Delta}f.iT$, et des moyens de filtrage 42 pour prélever la partie réelle du signal corrigé. Cette partie réelle est transmise aux moyens 25 de traitement de signaux de test.

Sur la figure 6 on a représenté sous forme de diagramme un exemple de procédé de test, dans le cas d'un système de transmission tel que représenté sur la figure 2 entre deux modems conformes à la recommandation V34 du CCITT. La recommandation V34 prévoit une phase d'apprentissage entre un modem appelant et un modem appelé, préalablement à une phase de transmission de données. Cette phase d'apprentissage a notamment pour but de choisir un certain nombre de paramètres pour la transmission, en fonction de caractéristiques du support de transmission utilisé. Elle se décompose en quatre phases appelées phase 1, 2, 3 et 4 dans la recommandation V34. Les opérations réalisées pendant ces différentes phases ne font pas l'objet de l'invention et ne sont donc pas décrites ici. Pour plus de détails on se reportera à la recommandation précitée.

A l'étape 50 le modem appelant initialise une connexion avec le modem appelé. A l'étape 51 le modem appelé décroche. Puis aux étapes 52 et 53 respectivement les modems appelés et appelant effectuent les opérations prévues à la phase 1. A l'étape 54, le modem appelant aborde la phase 2 en envoyant au modem appelé le signal B de fréquence $f_0$=1200Hz. Parallèlement, à l'étape 55 le modem appelé aborde la phase 2 en envoyant au modem appelant le signal A de fréquence $f_0$=2400Hz. A l'étape 56, le modem appelant reçoit le signal A et à l'étape 57 il calcule le décalage en fréquence $\overline{\Delta f}_{2400}$ en appliquant la méthode décrite ci-dessus en référence à la figure 4. Parallèlement, à l'étape 58, le modem appelé reçoit le signal B et à l'étape 59 il calcule le décalage en fréquence $\hat{\Delta} f_{1200}$ en appliquant la méthode décrite ci-dessus en référence à la figure 4. Aux étapes 60 et 61 respectivement les modems appelant et appelé poursuivent les opérations prévues aux phases 2, 3 et 4. A chaque réception d'un signal de test x(t) durant l'une de ces phases (événement 70 sur la figure 5), le modem concerné effectue la correction en fréquence de ce signal (opération 71) avant d'effectuer le traitement prévu par la recommandation (opération 72). L'opération 71 comporte les étapes suivantes: - étape 71a: calcul des coefficients complexes $y_i$ à partir des échantillons réels $x_i$ du signal x(t) reçu,

- étape 71b: multiplication de chaque coefficient $y_i$ par un échantillon de correction $c_i$,
- étape 71c: prélèvement de la partie réelle des échantillons complexes corrigés ainsi obtenus.

L'invention n'est pas limitée aux modes de réalisation qui viennent d'être décrit à titre d'exemple. Elle est applicable à tout système de transmission qui utilise une ou plusieurs porteuses, et qui permet de transmettre un signal sinusoïdal pur à un instant donné.

**Revendications**

1. Système de transmission entre au moins un émetteur et au moins un récepteur par l'intermédiaire d'un support de transmission susceptible d'introduire un décalage en fréquence et une atténuation, ledit émetteur comportant des moyens d'émission d'un signal sinusoïdal de fréquence connue, et ledit récepteur comportant des moyens de réception dudit signal sinusoïdal, et des moyens d'estimation dudit décalage en fréquence à partir du signal sinusoïdal reçu, caractérisé en ce que lesdits moyens d'estimation comportent des moyens d'échantillonnage du signal sinusoïdal reçu par le récepteur, des moyens de déphasage pour fournir des échantillons du signal sinusoïdal reçu déphasés de $+\Pi/2+p.2\Pi$ où p est un entier naturel, des moyens de calcul de ladite atténuation à partir d'au moins deux desdits échantillons déphasés, et des moyens de calcul dudit décalage en fréquence, à partir d'au moins deux desdits échantillons déphasés et de l'atténuation calculée.

2. Système de transmission selon la revendication 1, caractérisé en ce que les moyens de calcul de ladite atténuation comportent des moyens de calcul d'une valeur moyenne d'une somme du carré de deux échantillons déphasés de $+\Pi/2$.

3. Système de transmission selon la revendication 1, caractérisé en ce que ledit récepteur comporte un filtre de réception, et les moyens de calcul dudit décalage en fréquence utilisent deux échantillons déphasés de $+\Pi/2+p.2\Pi$ où la valeur de p est choisie de façon à ce que lesdits échantillons soient décorrélés.

4. Système de transmission selon la revendication 1, caractérisé en ce que les moyens de calcul dudit décalage comporte des moyens de calcul d'une valeur moyenne d'un produit desdits échantillons pour obtenir une fonction trigonométrique dudit décalage.

5. Système de transmission entre au moins un émetteur et au moins un récepteur par l'intermédiaire d'un support de transmission susceptible d'introduire un décalage en fréquence, ledit système comportant des moyens d'estimation dudit décalage en fréquence, caractérisé en ce qu'il comporte des moyens de test dudit support notamment par émission, réception puis analyse de signaux de test connus, pour en déduire des propriétés dudit support, et des moyens de correction dudit décalage en fréquence, lors de la réception d'au moins certains desdits signaux de test.

6. Récepteur destiné notamment à recevoir un signal sinusoïdal de fréquence connue transmis par un support de transmission susceptible d'introduire un décalage en fréquence et une atténuation, et comportant des moyens d'estimation dudit décalage en fréquence à partir du signal sinusoïdal reçu, caractérisé en ce que lesdits moyens d'estimation comportent des moyens d'échantillonnage du signal sinusoïdal reçu, des moyens de déphasage pour fournir des échantillons du signal sinusoïdal reçu, déphasés de $+\Pi/2+p.2\Pi$ où p est un enter naturel, des moyens de calcul de ladite atténuation à partir d'au moins deux desdits échantillons déphasés, et des moyens de calcul dudit décalage en fréquence, à partir d'au moins deux desdits échantillons déphasés, en tenant compte de l'estimation de ladite atténuation.

7. Récepteur destiné à recevoir des signaux transmis par un support de transmission susceptible d'introduire un décalage en fréquence, et comportant des moyens d'estimation dudit décalage en fréquence, caractérisé en ce qu'il comporte des moyens de test dudit support notamment par émission, réception puis analyse de signaux de test connus, pour en déduire des propriétés dudit support, et des moyens de correction dudit décalage en fréquence, lors de la réception d'au moins certains desdits signaux de test.

8. Procédé d'estimation du décalage en fréquence introduit sur une porteuse par un support de transmission, comportant une étape de transmission d'un signal sinusoïdal de fréquence connue, caractérisé en ce que, ledit support étant susceptible d'introduit une atténuation, il comporte, à la réception, une étape d'échantillonnage du signal sinusoïdal reçu, une étape de déphasage qui fournit des échantillons du signal sinusoïdal reçu déphasés de $+\Pi/2+p.2\Pi$ où p est un entier naturel, une étape de calcul de ladite atténuation à partir d'au moins deux desdits échantillons déphasés, et une étape de calcul dudit décalage en fréquence, à partir d'au moins deux desdits échantillons déphasés et de l'atténuation calculée.

9. Procédé de test d'un support de transmission susceptible d'introduire un décalage en fréquence, ledit procédé comportant des étapes d'émission de signaux de test connus, de réception desdits signaux de test, et d'analyse des signaux de test reçus pour en déduire des propriétés dudit support, caractérisé en ce qu'il comporte une étape préalable d'estimation dudit décalage en fréquence, et une étape de correction dudit décalage, lors des étapes suivantes dudit procédé de test, pour au moins certains des signaux de test reçus.

10. Programme d'ordinateur destiné à mettre en oeuvre le procédé selon la revendication 8.

FIG. 1

FIG. 2

**FIG. 3**

$$r(t) = R\cos\left(2\Pi\left(f_0 + \Delta f\right)t + \varphi\right) + n(t)$$  — K1

$$r_k = r\left(t = kT\right)$$
$$r_{k+2+8p} = r\left(t = (k+2+8p)T\right)$$  — K2

$$r_k \cdot r_{k+2+8p}$$  — K3

$$E\left(r_k \cdot r_{k+2+8p}\right)$$  — K4

$$R^2$$  — K5

$$\Delta f$$  — K6

**FIG. 4**

FIG. 5

FIG. 6